(19) Europäisches Patentamt
European Patent Office
Office européen des brevets

(11) **EP 4 685 801 A1**

(12) **EUROPEAN PATENT APPLICATION**
published in accordance with Art. 153(4) EPC

(43) Date of publication:
28.01.2026 Bulletin 2026/05

(21) Application number: 23930091.6

(22) Date of filing: 13.12.2023

(51) International Patent Classification (IPC):
$G11C\ 16/06^{(2006.01)}$        $G11C\ 16/30^{(2006.01)}$
$G11C\ 5/14^{(2006.01)}$         $H03L\ 7/06^{(2006.01)}$

(52) Cooperative Patent Classification (CPC):
G11C 5/02; G11C 5/06; G11C 5/14; G11C 11/4074;
G11C 11/408; G11C 11/4091; G11C 11/4096;
G11C 16/06; G11C 16/30; H03L 7/06

(86) International application number:
PCT/CN2023/138542

(87) International publication number:
WO 2024/198526 (03.10.2024 Gazette 2024/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.03.2023 CN 202310372877

(71) Applicant: Huawei Technologies Co., Ltd.
Shenzhen, Guangdong 518129 (CN)

(72) Inventors:
• LIANG, Xing
  Shenzhen, Guangdong 518129 (CN)
• ZHI, Xuankai
  Shenzhen, Guangdong 518129 (CN)

(74) Representative: Grünecker Patent- und
Rechtsanwälte
PartG mbB
Leopoldstraße 4
80802 München (DE)

(54) **POWER SUPPLY VOLTAGE GENERATION CIRCUIT, MEMORY, AND ELECTRONIC DEVICE**

(57) This application provides a power voltage generation circuit, a memory, and an electronic device, and relates to the field of integrated circuit technologies, to improve accuracy of a power voltage value output by a charge pump. The power voltage generation circuit includes the charge pump, a charge pump detection circuit, and an oscillator. The charge pump detection circuit includes a first sampling circuit, a second sampling circuit, and at least one inverter pair. The first sampling circuit is configured to: receive a first reference voltage signal and a power voltage signal output by the charge pump, and generate a first sampling current signal. The second sampling circuit is configured to: receive a second reference voltage signal, and generate a second sampling current signal. The inverter pair is configured to output a control signal based on the first sampling current signal and the second sampling current signal. The oscillator is configured to generate a clock signal based on the control signal, to control the charge pump to generate the power voltage signal. As a peripheral circuit of a memory array, the power voltage generation circuit may supply power for a data read/write operation.

FIG. 2

## Description

This application claims priority to Chinese Patent Application No. 202310372877.2, filed with the China National Intellectual Property Administration on March 30, 2023 and entitled "POWER VOLTAGE GENERATION CIRCUIT, MEMORY, AND ELECTRONIC DEVICE", which is incorporated herein by reference in its entirety.

## TECHNICAL FIELD

This application relates to the field of integrated circuit technologies, and in particular, to a power voltage generation circuit, a memory, and an electronic device.

## BACKGROUND

Currently, a memory has a plurality of memory channels (Channel), and the plurality of memory channels separately perform read and write operations.

Usually, a charge pump (Charge Pump, CP) is disposed for each memory channel, and the charge pump is configured to provide a power voltage for the read and write operations. A charge pump detection circuit is disposed for each charge pump. The charge pump detection circuit includes a voltage comparator and a series resistor voltage divider that are connected to each other. Two ends of the series resistor voltage divider respectively receive a power voltage output by the charge pump and a first reference voltage, and the series resistor voltage divider performs voltage division, to obtain a sampling voltage signal. The sampling voltage signal and a second reference voltage are input to the voltage comparator for comparison, and an output signal of the voltage comparator is used to represent whether the power voltage reaches a target voltage.

However, in the charge pump detection circuit, because the power voltage and the first reference voltage are input to the series resistor voltage divider, to obtain the sampling voltage signal through voltage division, a current is generated on the series resistor voltage divider, and a current is generated on a transmission trace of the first reference voltage. As a result, a voltage drop is generated in a process of transmitting the first reference voltage, resulting in a deviation between the power voltage output by the charge pump and the target voltage.

## SUMMARY

Embodiments of this application provide a power voltage generation circuit, a memory, and an electronic device, to improve accuracy of a power voltage value output by a charge pump.

To achieve the foregoing objective, the following technical solutions are used in embodiments of this application.

According to a first aspect, a power voltage generation circuit is provided. The power voltage generation circuit may be used as a peripheral circuit of a memory array. The memory array has a plurality of memory channels. Usually, one power voltage generation circuit is disposed for each memory channel, to provide a power voltage for data read and write operations.

The power voltage generation circuit includes a charge pump, a charge pump detection circuit, and an oscillator. An output end of the charge pump is configured to output a power voltage signal.

The charge pump detection circuit includes a first sampling circuit, a second sampling circuit, and at least one inverter pair. The first sampling circuit is configured to: receive a first reference voltage signal and the power voltage signal, and generate a first sampling current signal. The second sampling circuit is configured to: receive a second reference voltage signal, and generate a second sampling current signal. The inverter pair is electrically connected to the first sampling circuit and the second sampling circuit, and the inverter pair is configured to output a control signal based on the first sampling current signal and the second sampling current signal.

The oscillator is electrically connected to the inverter pair, and the oscillator is configured to generate a clock signal based on the control signal. The charge pump is electrically connected to the oscillator, and the charge pump is configured to generate the power voltage signal based on the clock signal.

According to the power voltage generation circuit provided in the foregoing embodiment of this application, in the charge pump detection circuit, the first sampling circuit receives the power voltage signal from the charge pump and the first reference voltage signal through a transmission trace, and generates the first sampling current signal. In this way, almost no current is generated on the transmission trace of the first reference voltage signal, thereby avoiding a large voltage drop generated in a process of transmitting the first reference voltage signal, and improving accuracy of the received first reference voltage signal.

In addition, the second sampling circuit receives the second reference voltage signal from a second reference voltage end, and generates the second sampling current signal.

Based on this, the inverter pair is electrically connected to the first sampling circuit and the second sampling circuit, and the inverter pair may output the control signal based on the first sampling current signal and the second sampling current signal. The oscillator generates the clock signal in response to the control signal, and the charge pump may generate and output the power voltage signal based on the clock signal. When the accuracy of the first reference voltage signal is improved, accuracy of a power voltage value output by the charge pump is improved.

In some embodiments, a target voltage value of the power voltage signal is a difference between the first reference voltage signal and the second reference voltage signal.

In some embodiments, the charge pump detection circuit further includes a first bias voltage circuit and an isolation circuit. The first bias voltage circuit is electrically connected to a first reference voltage end and the output end of the charge pump, and the first bias voltage circuit is configured to: receive the first reference voltage signal and the power voltage signal, and output a first bias voltage.

The isolation circuit is electrically connected to the first bias voltage circuit, and is connected between the first sampling circuit and the second sampling circuit.

The first bias voltage circuit and the isolation circuit are added, and the isolation circuit is electrically connected to the first bias voltage circuit, and is connected between the first sampling circuit and the second sampling circuit. The isolation circuit may reduce a voltage value change of the first sampling current signal under control of the first bias voltage from the first bias voltage circuit, to ensure accuracy of the control signal output by the inverter pair, thereby ensuring the accuracy of the power voltage value output by the charge pump.

In some embodiments, the second sampling circuit includes a second sampling sub-circuit and a current mirror, and the second sampling sub-circuit is configured to: receive the second reference voltage signal and generate a third sampling current signal. The current mirror includes a current input end and a first current output end. The current input end is electrically connected to the second sampling sub-circuit, to receive the third sampling current signal. The first current output end is electrically connected to the first sampling circuit and the inverter pair, and is configured to output the second sampling current signal.

The charge pump detection circuit further includes a second bias voltage circuit. The second bias voltage circuit is electrically connected to the second reference voltage end and the current mirror, and the second bias voltage circuit is configured to: receive the second reference voltage signal, and output a second bias voltage to the current mirror.

It may be understood that the current mirror receives the third sampling current signal, and the current mirror may replicate the third sampling current signal, to generate and output the second sampling current signal. A direction of the second sampling current signal is the same as a direction of the third sampling current signal, so that the second sampling current signal and the first sampling current signal are in a same direction, and the first sampling current signal and the second sampling current signal may generate a high or low level.

The second bias voltage circuit receives the second reference voltage signal from the second reference voltage end, and outputs the second bias voltage to the current mirror, to control the current mirror to work.

In some embodiments, the inverter pair includes a first-stage inverter and a second-stage inverter.

The first-stage inverter is electrically connected to the first sampling circuit and the second sampling circuit. The first-stage inverter is configured to output a first drive voltage signal based on the first sampling current signal and the second sampling current signal. The second-stage inverter is electrically connected to the first-stage inverter, and the second-stage inverter is configured to: receive the first drive voltage signal, and output a second drive voltage signal. The second drive voltage signal is the control signal.

The inverter pair is disposed, and each inverter pair includes two inverters (a first-stage inverter and a second-stage inverter), to ensure that the output second drive voltage signal is the same in polarity as a voltage generated by the first sampling current signal and a voltage generated by the second sampling current signal.

In addition, the inverter may be configured to increase a swing of the output signal; and the second drive voltage signal is used as the control signal, so that a driving capability of the control signal to the oscillator can be improved.

In some embodiments, the current mirror further includes a second current output end, and the second current output end is configured to output a reference current signal. The charge pump detection circuit further includes a third sampling circuit, and the third sampling circuit is electrically connected to the second reference voltage end. The third sampling circuit is configured to: receive the second reference voltage signal, and generate a fourth sampling current signal. The first-stage inverter is further electrically connected to the second current output end and the third sampling circuit.

It may be understood that the reference current signal and the fourth sampling current signal separately provide a bias current for the first-stage inverter, and the first-stage inverter is a current starving inverter, so that a swing of the first drive voltage signal can be increased.

In some embodiments, the first sampling circuit includes a first transistor. A control electrode of the first transistor is electrically connected to the first reference voltage end, and a first electrode of the first transistor is electrically connected to the output end of the charge pump.

In the foregoing embodiment, the first reference voltage end is electrically connected to a gate of the first transistor, and almost no current is generated on the transmission trace of the first reference voltage signal, thereby avoiding a large voltage drop generated in a process of transmitting the first reference voltage signal on the trace, and helping improve the accuracy of the power voltage value output by the charge pump.

In addition, because there is almost no current on the transmission trace of the first reference voltage signal, a width of the trace is reduced, and trace channel space is saved.

In some embodiments, the charge pump detection circuit further includes a first voltage end and a second voltage end.

The second sampling circuit includes the second sampling sub-circuit and the current mirror. The second sampling sub-circuit includes a second transistor. A control electrode of the second transistor is electrically connected to the second reference voltage end, and a first electrode of the second transistor is electrically connected to the first voltage end.

The current mirror includes a third transistor to a sixth transistor. A first electrode of the third transistor is electrically connected to the second voltage end, a second electrode of the third transistor is electrically connected to a first electrode of the fourth transistor, and a second electrode of the fourth transistor is electrically connected to a control electrode of the third transistor and a second electrode of the second transistor.

A first electrode of the fifth transistor is electrically connected to the second voltage end, a second electrode of the fifth transistor is electrically connected to a first electrode of the sixth transistor, and a second electrode of the sixth transistor is electrically connected to a second electrode of the first transistor.

The control electrode of the third transistor is electrically connected to a control electrode of the fifth transistor, and a control electrode of the fourth transistor is electrically connected to a control electrode of the sixth transistor.

In the foregoing embodiment, the second reference voltage end is electrically connected to a gate of the second transistor, and almost no current is generated on a transmission trace of the second reference voltage signal, thereby avoiding a large voltage drop generated in a process of transmitting the second reference voltage signal on the trace, and helping improve the accuracy of the power voltage value output by the charge pump.

In addition, because there is almost no current on the transmission trace of the second reference voltage signal, a width of the trace is reduced, and trace channel space is saved.

In some embodiments, the inverter pair includes the first-stage inverter and the second-stage inverter. The first-stage inverter includes a seventh transistor and an eighth transistor. A control electrode of the seventh transistor is electrically connected to the second electrode of the first transistor and the second electrode of the sixth transistor, and a first electrode of the seventh transistor is electrically connected to the first voltage end. A control electrode of the eighth transistor is electrically connected to the second electrode of the first transistor and the second electrode of the sixth transistor, a first electrode of the eighth transistor is electrically connected to the second voltage end, and a second electrode of the eighth transistor is electrically connected to a second electrode of the seventh transistor.

The second-stage inverter includes a ninth transistor and a tenth transistor. A control electrode of the ninth transistor is electrically connected to the second electrode of the seventh transistor and the second electrode of the eighth transistor, and a first electrode of the ninth transistor is electrically connected to the first voltage end. A control electrode of the tenth transistor is electrically connected to the second electrode of the seventh transistor and the second electrode of the eighth transistor, a first electrode of the tenth transistor is electrically connected to the second voltage end, and a second electrode of the tenth transistor is electrically connected to a second electrode of the ninth transistor.

In some embodiments, the first bias voltage circuit includes an eleventh transistor and a twelfth transistor. A control electrode of the eleventh transistor is electrically connected to the first reference voltage end, and a first electrode of the eleventh transistor is electrically connected to the output end of the charge pump. A first electrode of the twelfth transistor is electrically connected to a control electrode and a second electrode of the eleventh transistor, and a second electrode of the twelfth transistor is electrically connected to the first voltage end.

The isolation circuit includes a thirteenth transistor. The first transistor is electrically connected to the sixth transistor via the thirteenth transistor. A control electrode of the thirteenth transistor is electrically connected to the control electrode of the twelfth transistor.

In some embodiments, the second bias voltage circuit includes a fourteenth transistor and a fifteenth transistor. A control electrode of the fourteenth transistor is electrically connected to the second reference voltage end, and a first electrode of the fourteenth transistor is electrically connected to the first voltage end. A first electrode of the fifteenth transistor is electrically connected to the second voltage end, and a second electrode of the fifteenth transistor is electrically connected to a control electrode, a second electrode of the fourteenth transistor, the control electrode of the fourth transistor, and the control electrode of the sixth transistor.

In some embodiments, the current mirror further includes a sixteenth transistor and a seventeenth transistor. A control electrode of the sixteenth transistor is electrically connected to the control electrode of the third transistor, and a first electrode of the sixteenth transistor is electrically connected to the second voltage end. A control electrode of the seventeenth transistor is electrically connected to the control electrode of the fifteenth transistor, a first electrode of the seventeenth transistor is electrically connected to a second electrode of the sixteenth transistor, and a second electrode of the seventeenth transistor is electrically connected to the first electrode of the eighth transistor.

The third sampling circuit includes an eighteenth transistor. A control electrode of the eighteenth transistor is electrically connected to the second reference voltage end, a first electrode of the eighteenth transistor is electrically connected to the first voltage end, and a second electrode of the eighteenth transistor is electrically connected to the first electrode of the seventh transistor.

According to a second aspect, a memory is provided. The memory may be a DRAM, an SRAM, or a flash memory. The memory includes a memory array and the power voltage generation circuit in any one of the foregoing embodiments. The memory array is electrically connected to the power voltage generation circuit.

In some embodiments, the memory includes a plurality of power voltage generation circuits, and the memory array is electrically connected to the plurality of power voltage generation circuits.

In some embodiments, the memory further includes a voltage generator, and the voltage generator is configured to output the first reference voltage signal. In the charge pump detection circuit of the power voltage generation circuit, the first reference voltage end is electrically connected to the voltage generator.

It may be understood that almost no current is generated on a transmission trace of the first reference voltage signal, thereby avoiding a large voltage drop generated in a process of transmitting the first reference voltage signal on the trace, avoiding a large deviation between a voltage value received by the first reference voltage end and a voltage value output by the voltage generator, and helping improve accuracy of a power voltage value output by the charge pump.

According to a third aspect, an electronic device is provided. The electronic device may be, for example, a consumer electronic product, a home electronic product, a vehicle-mounted electronic product, a financial terminal product, or a communication electronic product. The electronic device includes a processor and the memory in any one of the foregoing embodiments. The memory is electrically connected to the processor.

It may be understood that, for beneficial effects that can be achieved by the memory and the electronic device provided in the foregoing embodiments of this application, refer to the foregoing beneficial effects of the power voltage generation circuit. Details are not described herein again.

## BRIEF DESCRIPTION OF DRAWINGS

To describe technical solutions in this application more clearly, the following briefly describes accompanying drawings used in describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual time sequence of a signal, and the like in embodiments of this application.

FIG. 1 is a diagram of an architecture of an electronic device according to an embodiment of this application;

FIG. 2 is an exploded view of a mobile phone according to an embodiment of this application;

FIG. 3 is a diagram of an architecture of an internal memory according to an embodiment of this application;

FIG. 4 is a block diagram of a structure of a power voltage generation circuit according to an embodiment of this application;

FIG. 5 is a block diagram of another structure of a power voltage generation circuit according to an embodiment of this application;

FIG. 6 is a block diagram of a structure of a charge pump detection circuit according to an embodiment of this application;

FIG. 7 is a circuit diagram of the charge pump detection circuit in FIG. 6; and

FIG. 8 is a block diagram of a structure of a memory according to an embodiment of this application.

## DESCRIPTION OF EMBODIMENTS

The following clearly and completely describes technical solutions in some embodiments of this application with reference to accompanying drawings. It is clear that the described embodiments are merely a part rather than all of embodiments of this application. All other embodiments obtained by a person of ordinary skill in the art based on embodiments of this application shall fall within the protection scope of this application.

Unless otherwise required by the context, throughout the specification and claims, the term "include" is interpreted as "open and inclusive", that is, "include but not limited to". In the description of the specification, terms such as "an embodiment", "some embodiments", "example embodiments", "examples", or "some examples" are intended to indicate that specific features, structures, materials, or characteristics related to the embodiments or examples are included in at least one embodiment or example of this application. The schematic representations of the foregoing terms do not necessarily refer to a same embodiment or example. In addition, the specific features, structures, materials, or characteristics may be included in any one or more embodiments or examples in any appropriate manner.

The terms "first" and "second" mentioned below are merely intended for a purpose of description, and shall not be understood as an indication or implication of relative importance or an implicit indication of a quantity of indicated technical features. Therefore, a feature limited by "first" or "second" may explicitly indicate or implicitly include one or more such features. In the description of embodiments of this application, unless otherwise specified, "a plurality of" means two or more than two.

In the description of some embodiments, expressions of "connection" and extensions thereof may be used. The term "connection" should be understood in a broad sense. For example, the "connection" may be a fixed connection, a detachable connection, or an integrated connection, or may be a direct connection or an indirect connection implemented via an intermediate medium. Embodiments disclosed herein are not necessarily limited to content of this specification.

"A and/or B" includes the following three combinations: only A, only B, and a combination of A and B.

The use of "configured to" in this specification implies an open and inclusive language, and does not exclude a device that is applicable to or configured to perform an additional task or step.

In addition, the use of "based on" implies openness and inclusiveness, since processes, steps, calculations, or other actions "based on" one or more of conditions or values may be based in practice on additional conditions or values outside the described values.

In this specification, a "node" does not represent an actual component, but represents a convergence point of a related electrical connection in a schematic. In other words, these nodes are nodes equivalent to convergence points of related electrical connections in the schematic.

Some embodiments of this application provide an electronic device. The electronic device may be different types of user equipment or terminal devices such as a mobile phone, a tablet computer, a personal digital assistant (Personal Digital Assistant, PDA), a television, an intelligent wearable product (for example, a smartwatch or a smart band), a virtual reality (Virtual Reality, VR) terminal device, an augmented reality (Augmented Reality, AR) terminal device, a small-sized charging household appliance (for example, a soy milk maker or a robotic vacuum cleaner), an uncrewed aerial vehicle, a radar, an aerospace device, and a vehicle-mounted device. The electronic device may alternatively be a network device like a base station. A specific form of the electronic device is not specifically limited in embodiments of this application.

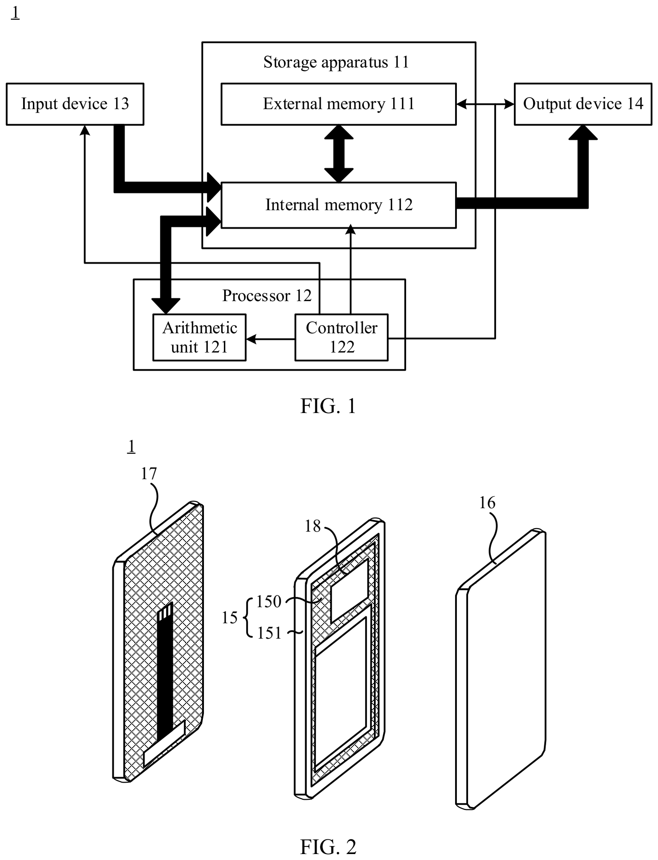

FIG. 1 is a diagram of an architecture of an electronic device according to an embodiment of this application.

Refer to FIG. 1. An electronic device 1 includes components such as a storage apparatus 11, a processor 12, an input device 13, and an output device 14. A person skilled in the art may understand that the architecture of the electronic device 1 shown in FIG. 1 does not constitute a limitation on the electronic device 1. The electronic device 1 may include more or fewer components than those shown in FIG. 1, or may include a combination of some of the components shown in FIG. 1, or may include components arranged differently from those shown in FIG. 1.

The storage apparatus 11 is configured to store a software program and a module. The storage apparatus 11 mainly includes a program storage area and a data storage area. The program storage area may store and back up an operating system, an application required by at least one function (such as a sound play function or an image play function), and the like. The data storage area may store data (such as audio data, image data, and a phone book) created based on use of the electronic device 1, and the like. In addition, the storage apparatus 11 includes an external memory 111 and an internal memory 112. Data stored in the external memory 111 and the internal memory 112 may be transmitted to each other. The external memory 111 may include, for example, a hard disk, a USB flash drive, and a floppy disk. The internal memory 112 may include, for example, a random access memory (Random Access Memory, RAM) and a read-only memory (Read-Only Memory, ROM). The random access memory may include a dynamic random access memory (Dynamic Random Access Memory, DRAM) and a static random access memory (Static Random Access Memory, SRAM). The read-only memory may include a flash memory (flash memory).

The processor 12 is a control center of the electronic device 1, is connected to all parts of the entire electronic device 1 through various interfaces and lines, and performs various functions and data processing of the electronic device 1 by running or executing the software program and/or the module stored in the storage apparatus 11 and invoking data stored in the storage apparatus 11, thereby performing overall monitoring on the electronic device 1. Optionally, the processor 12 may include one or more processing units. For example, the processor 12 may include an application processor (Application Processor, AP), a modem processor, a graphics processing unit (Graphics Processing Unit, GPU), and the like. Different processing units may be independent components, or may be integrated into one or more processors. For example, the processor 12 may integrate an application processor and a modem processor. The application processor mainly processes an operating system, a user interface, an application, and the like. The modem processor mainly processes wireless communication. It may be understood that the modem processor may be not integrated into the processor 12. The application processor may be, for example, a central processing unit (Central Processing Unit, CPU). In FIG. 1, an example in which the processor 12 is a CPU is used. The CPU may include an arithmetic unit 121 and a controller 122. The arithmetic unit 121 obtains data stored in the internal memory 112, processes the data stored in the internal memory 112, and usually sends a processing result back to the internal memory 112. The controller 122 may control the arithmetic unit 121 to process the data, and the controller 122 may further control the external memory 111 and the internal memory 112 to read or write data.

The input device 13 is configured to: receive input digit or character information, and generate key signal input related to user setting and function control of the electronic device. For example, the input device 13 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any proper object or accessory such as a finger or a stylus pen), and drive a corresponding connection apparatus based on a preset program. The controller 122 in the processor 12 may further control the input device 13 to receive an input signal or not to receive an input signal. In addition, the input digit or character information received by the input device 13 and the key signal input related to the user setting and function control of the electronic device may be stored in the internal memory 112.

The output device 14 is configured to: output an input of the input device 13, and output a signal corresponding to data in the internal memory 112. For example, the output device 14 outputs a sound signal or a video signal. The controller 122 in the processor 12 may further control the output device 14 to output a signal or not to output a signal.

It should be noted that a thick arrow in FIG. 1 represents data transmission, and a direction of the thick arrow represents a data transmission direction. For example, a unidirectional arrow between the input device 13 and the internal memory 112 represents that data received by the input device 13 is transmitted to the internal memory 112. For another example, a bidirectional arrow between the arithmetic unit 121 and the internal memory 112 represents that the data stored in the internal memory 112 may be transmitted to the arithmetic unit 121, and data processed by the arithmetic unit 121 may be transmitted to the internal memory 112. A thin arrow in FIG. 1 represents a component that can be controlled by the controller 122. For example, the controller 122 may control the external memory 111, the internal memory 112, the arithmetic unit 121, the input device 13, the output device 14, and the like.

For ease of further describing the structure of the electronic device 1, the following uses an example in which the electronic device 1 is a mobile phone for description.

FIG. 2 is an exploded view of the mobile phone according to an embodiment of this application.

Refer to FIG. 2. The electronic device 1 may further include a middle frame 15, a rear housing 16, and a display 17. The rear housing 16 and the display 17 are respectively located on two opposite sides of the middle frame 15, and the middle frame 15 and the display 17 are disposed in the rear housing 16. The middle frame 15 includes a bearing plate 150 configured to bear the display 17, and a frame 151 that surrounds the bearing plate 150.

Still refer to FIG. 2. The electronic device 1 may further include a circuit board 18. The circuit board 18 is disposed on a side that is of the bearing plate 150 and that is close to the rear housing 16. The internal memory 112 in the electronic device 1 may be disposed on the circuit board 18. The internal memory 112 is electrically connected to the circuit board 18.

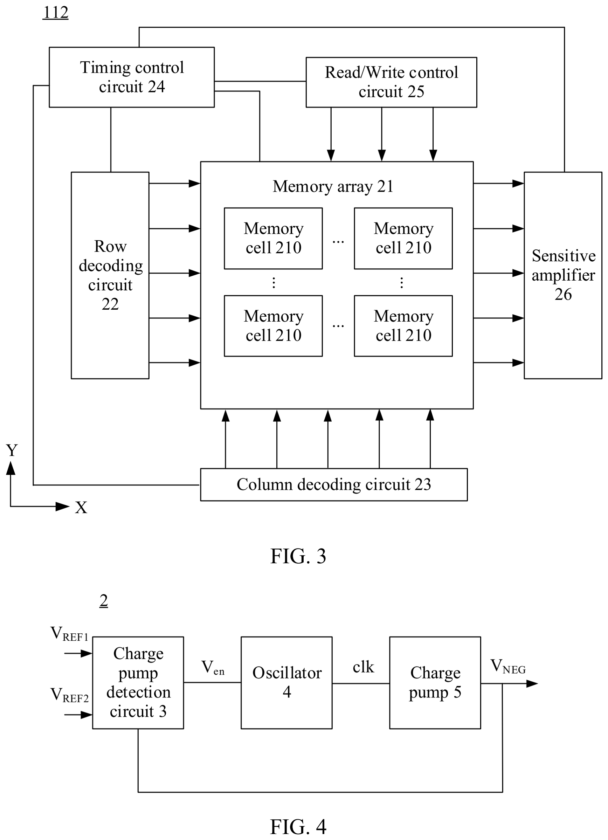

Currently, a DRAM is one of mainstream memories. A 3D DRAM is a new type of memory in which a memory cell is stacked above a logic cell, and has a high memory density. In the following embodiment, an example in which the internal memory 112 is a DRAM is used for description. FIG. 3 is a diagram of an architecture of an internal memory according to an embodiment of this application.

Refer to FIG. 3. The internal memory 112 includes a memory array 21, a row decoding circuit 22, a column decoding circuit 23, a timing control circuit 24, a read/write control circuit 25, and at least one sensitive amplifier 26.

The memory array 21 includes a plurality of memory cells 210 arranged in an array, and the plurality of memory cells 210 include a plurality of rows arranged in a first direction X and a plurality of columns arranged in a second direction Y. The first direction X and the second direction Y intersect. For example, the first direction X and the second direction Y are perpendicular to each other.

The timing control circuit 24 is electrically connected to the row decoding circuit 22, the column decoding circuit 23, the memory array 21, the read/write control circuit 25, and the sensitive amplifier 26 separately. The timing control circuit 24 is configured to perform timing control on each circuit.

The row decoding circuit 22 is electrically connected to the memory array 21, and the row decoding circuit 22 is configured to select a memory cell 210 in a corresponding row based on a row address, to address the memory cell 210 in the corresponding row.

The column decoding circuit 23 is electrically connected to the memory array 21. After memory cells 210 in corresponding rows are selected, the column decoding circuit 23 is configured to address a memory cell 210 in a corresponding column based on a column address, to select a memory cell 210 that needs to perform a read operation or a write operation.

The read/write control circuit 25 is electrically connected to the memory array 21, and the read/write control circuit 25 is configured to control the selected memory cell 210 to perform a read operation or a write operation.

The sensitive amplifier 26 is electrically connected to the memory array 21. The sensitive amplifier 26 is configured: to read, amplify, and output data information stored in the selected memory cell 210, to implement a data read operation; or input a data signal to the selected memory cell 210, to implement a data write operation.

The memory array 21 has a plurality of memory channels (Channel), and each memory channel includes a plurality of memory cells 210. Usually, a charge pump (Charge Pump, CP) is disposed for each memory channel, and the charge pump is configured to provide a power voltage for read and write operations of the memory cell 210. A charge pump detection circuit is disposed for each charge pump, and is configured to detect whether the power voltage output by the charge pump reaches a target value.

An existing charge pump detection circuit uses a voltage comparison manner. The charge pump detection circuit includes a voltage comparator and a series resistor voltage divider that are connected to each other. Two ends of the series resistor voltage divider are respectively connected to a power voltage output by the charge pump and a first reference voltage, and the series resistor voltage divider performs voltage division, to obtain a sampling voltage signal. The sampling voltage signal and a second reference voltage are input to the voltage comparator for comparison, and an output signal of the voltage comparator is used to represent whether the power voltage reaches a target voltage.

An output end of the charge pump detection circuit is electrically connected to the charge pump via an oscillator, and the output signal of the voltage comparator is transmitted to the oscillator, to control working of the oscillator. For example, when the power voltage is higher than the target voltage, the output signal of the voltage comparator is at a high level, the output signal controls the oscillator to start working, and a clock signal generated by the oscillator is input to the charge pump, to control the charge pump to start working and pull down the power voltage. When the power voltage is lower than the target voltage, the output signal of the voltage comparator is at a low level, the output signal controls the oscillator to stop outputting a clock signal, the charge pump stops working accordingly, and the power voltage is continuously pulled up under a load of the charge pump. The foregoing operations are repeated until the power voltage reaches the target voltage. This dynamically controls a power voltage.

However, the first reference voltage is generated by a voltage generator (Generator), and is transmitted to the charge pump detection circuit through a trace. In the charge pump detection circuit, because the power voltage and the first reference voltage are input to the series resistor voltage divider, to obtain the sampling voltage signal through voltage division, a current is generated on the series resistor voltage divider, and a current is generated on a transmission trace of the first reference voltage. The trace used to transmit the first reference voltage has resistance. As a result, a voltage drop (IR Drop) is generated in a process of transmitting the first reference voltage on the trace, and a deviation occurs in the first reference voltage, resulting in a deviation between the power voltage output by the charge pump and the target voltage.

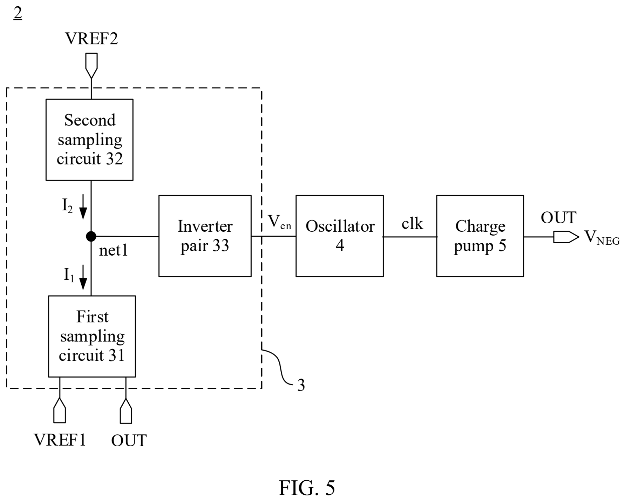

To resolve the foregoing problem, some embodiments of this application provide a power voltage generation circuit. FIG. 4 is a block diagram of a structure of a power voltage generation circuit according to an embodiment of this application. FIG. 5 is a block diagram of another structure of the power voltage generation circuit according to an embodiment of this application.

Refer to FIG. 4 and FIG. 5. A power voltage generation circuit 2 includes a charge pump detection circuit 3, an oscillator 4, and a charge pump 5. An output end OUT of the charge pump 5 is configured to output a power voltage signal $V_{NEG}$. For example, the power voltage signal $V_{NEG}$ is a negative voltage.

Still refer to FIG. 4 and FIG. 5. The charge pump detection circuit 3 includes a first reference voltage end VREF1 and a second reference voltage end VREF2. The first reference voltage end VREF1 is configured to receive a first reference voltage signal $V_{REF1}$, and the second reference voltage end VREF2 is configured to receive a second reference voltage signal $V_{REF2}$.

For example, a target voltage value of the power voltage signal $V_{NEG}$ is a difference between the first reference voltage signal $V_{REF1}$ and the second reference voltage signal $V_{REF2}$.

The charge pump detection circuit 3 further includes a first sampling circuit 31, a second sampling circuit 32, and at least one inverter pair 33. The first sampling circuit 31 is electrically connected to the first reference voltage end VREF1 and the output end OUT of the charge pump 5. The first sampling circuit 31 is configured to: receive the first reference voltage signal $V_{REF1}$ from the first reference voltage end VREF1 and the power voltage signal $V_{NEG}$ from the charge pump 5, and generate a first sampling current signal $I_1$.

For example, a current value of the first sampling current signal $I_1$ is related to a difference between the first reference voltage signal $V_{REF1}$ and the power voltage signal $V_{NEG}$.

The second sampling circuit 32 is electrically connected to the second reference voltage end VREF2, and the second sampling circuit 32 is configured to: receive the second reference voltage signal $V_{REF2}$ from the second reference voltage end VREF2, and generate a second sampling current signal $I_2$.

For example, a current value of the second sampling current signal $I_2$ is related to a voltage value of the second reference voltage signal $V_{REF2}$.

The charge pump detection circuit 3 may include one or more inverter pairs 33. FIG. 5 shows a case in which the charge pump detection circuit 3 includes one inverter pair 33. Each inverter pair 33 includes two inverters, and the inverter pair 33 is electrically connected to the first sampling circuit 31 and the second sampling circuit 32. The inverter pair 33 is configured to output a control signal $V_{en}$ based on the first sampling current signal $I_1$ from the first sampling circuit 31 and the second sampling current signal $I_2$ from the second sampling circuit 32.

For example, refer to FIG. 5. The inverter pair 33, the first sampling circuit 31, and the second sampling circuit 32 are all connected to a first node net1. When the first sampling current signal $I_1$ and the second sampling current signal $I_2$ are compared at the first node net1, a voltage value of the first node net1 is affected (the voltage value of the first node net1 is pulled up or pulled down), so that a comparison voltage is generated at the first node net1. The inverter pair 33 may output the control signal

$V_{en}$ based on the comparison voltage.

The oscillator 4 is electrically connected to the inverter pair 33 of the charge pump detection circuit 3 and an input end of the charge pump 5, and the oscillator 4 is configured to generate a clock signal clk based on the control signal $V_{en}$ from the inverter pair 33. The charge pump 5 is configured to generate and output the power voltage signal $V_{NEG}$ based on the clock signal clk from the oscillator 4.

According to the power voltage generation circuit 2 provided in the foregoing embodiment of this application, in the charge pump detection circuit 3, the first reference voltage end $V_{REF1}$ receives the first reference voltage signal $V_{REF1}$ through a transmission trace, the first sampling circuit 31 receives the first reference voltage signal $V_{REF1}$ through the first reference voltage end $V_{REF1}$, receives the power voltage signal $V_{NEG}$ from the charge pump 5, and generates the first sampling current signal $I_1$. In this way, almost no current is generated on the transmission trace of the first reference voltage signal $V_{REF1}$, thereby avoiding a large voltage drop generated in a process of transmitting the first reference voltage signal $V_{REF1}$ on the trace, and improving accuracy of the received first reference voltage signal $V_{REF1}$.

In addition, the second sampling circuit 32 receives the second reference voltage signal $V_{REF2}$ from the second reference voltage end VREF2, and generates the second sampling current signal $I_2$.

Based on this, the inverter pair 33 is electrically connected to the first sampling circuit 31 and the second sampling circuit 32, and the inverter pair 33 may output the control signal $V_{en}$ based on the first sampling current signal $I_1$ and the second sampling current signal $I_2$. The oscillator 4 generates the clock signal clk in response to the control signal $V_{en}$, and the charge pump 5 may generate and output the power voltage signal $V_{NEG}$ based on the clock signal clk. When the accuracy of the first reference voltage signal $V_{REF1}$ is improved, accuracy of a power voltage value output by the charge pump 5 is improved.

For example, the current value of the first sampling current signal $I_1$ is related to the difference between the first reference voltage signal $V_{REF1}$ and the power voltage signal $V_{NEG}$, and the current value of the second sampling current signal $I_2$ is related to the voltage value of the second reference voltage signal $V_{REF2}$. For example, the current value of the first sampling current signal $I_1$ is positively correlated with the difference between the first reference voltage signal $V_{REF1}$ and the power voltage signal $V_{NEG}$. The current value of the second sampling current signal $I_2$ is positively correlated with the voltage value of the second reference voltage signal $V_{REF2}$.

The target voltage value of the power voltage signal $V_{NEG}$ is equal to the difference between the first reference voltage signal $V_{REF1}$ and the second reference voltage signal $V_{REF2}$, that is, a difference between the first reference voltage signal $V_{REF1}$ and the target voltage value of the power voltage signal $V_{NEG}$ is equal to the second reference voltage signal $V_{REF2}$.

Based on this, the power voltage signal $V_{NEG}$ is a negative voltage, and when the power voltage signal $V_{NEG}$ is higher than the target voltage value, the difference between the first reference voltage signal $V_{REF1}$ and the power voltage signal $V_{NEG}$ is less than the voltage value of the second reference voltage signal $V_{REF2}$. Therefore, the first sampling current signal $I_1$ is less than the second sampling current signal $I_2$, and the voltage value of the first node net1 may be pulled up. The control signal $V_{en}$ output by the inverter pair 33 is at a high level, and the oscillator 4 is turned on under control of the control signal $V_{en}$, to transmit the clock signal clk to the charge pump 5, so as to control the charge pump 5 to pull down the output power voltage signal $V_{NEG}$.

When the power voltage signal $V_{NEG}$ is less than the target voltage value, the difference between the first reference voltage signal $V_{REF1}$ and the power voltage signal $V_{NEG}$ is greater than the voltage value of the second reference voltage signal $V_{REF2}$. Therefore, the first sampling current signal $I_1$ is greater than the second sampling current signal $I_2$, and the voltage value of the first node net1 may be pulled down. The control signal $V_{en}$ output by the inverter pair 33 is at a low level, and the oscillator 4 stops outputting the clock signal under control of the control signal $V_{en}$, and the charge pump 5 stops working accordingly. The power voltage signal $V_{NEG}$ is continuously pulled up under the load of the charge pump 5 until the power voltage signal $V_{NEG}$ reaches the target voltage value. This dynamically controls a power voltage.

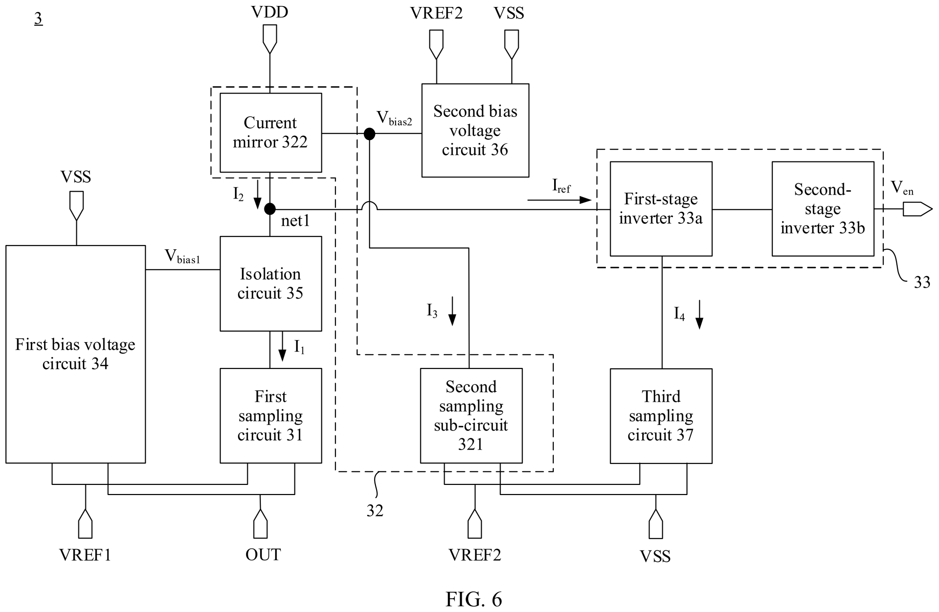

FIG. 6 is a block diagram of a structure of a charge pump detection circuit according to an embodiment of this application. FIG. 6 also shows the case in which the charge pump detection circuit 3 includes one inverter pair 33.

Refer to FIG. 6. The charge pump detection circuit 3 further includes a first voltage end VSS and a second voltage end VDD. The first voltage end VSS is configured to receive a first voltage. For example, the first voltage is at a low level. The second voltage end VDD is configured to receive a second voltage. For example, the second voltage is at a high level.

Still refer to FIG. 6. The charge pump detection circuit 3 further includes a first bias voltage circuit 34 and an isolation circuit 35.

The first bias voltage circuit 34 is electrically connected to the first reference voltage end VREF1 and the output end OUT of the charge pump 5, and the first bias voltage circuit 34 is configured to: receive the first reference voltage signal $V_{REF1}$ from the first reference voltage end VREF1 and the power voltage signal $V_{NEG}$ from the charge pump 5, and output a first bias voltage $V_{bias1}$.

For example, the first bias voltage circuit 34 is further electrically connected to the first voltage end VSS.

The isolation circuit 35 is electrically connected to the first bias voltage circuit 34, and is connected between the first sampling circuit 31 and the second sampling circuit 32.

For example, refer to FIG. 6. A connection path between the first sampling circuit 31 and the second sampling circuit 32 has a first node net1, and the first sampling current signal $I_1$ and the second sampling current signal $I_2$ are compared at the first node net1 to generate a comparison voltage, so that the voltage value of the first node net1 is changed.

The first bias voltage circuit 34 and the isolation circuit 35 are added, the isolation circuit 35 is electrically connected to the first bias voltage circuit 34, and is connected between the first sampling circuit 31 and the second sampling circuit 32. For example, the isolation circuit 35 is connected between the first sampling circuit 31 and the first node net1. Under control of the first bias voltage $V_{bias1}$ from the first bias voltage circuit 34, the isolation circuit 35 may reduce impact of a voltage value change of the first node net1 on the first sampling current signal $I_1$, and reduce a voltage value change of the first sampling current signal $I_1$, to ensure accuracy of voltage comparison and accuracy of the control signal $V_{en}$ output by the inverter pair 33, thereby ensuring accuracy of the power voltage value output by the charge pump 5.

In some embodiments, refer to FIG. 6. The second sampling circuit 32 includes a second sampling sub-circuit 321 and a current mirror 322. The second sampling sub-circuit 321 is electrically connected to the second reference voltage end VREF2, and the second sampling sub-circuit 321 is configured to: receive the second reference voltage signal $V_{REF2}$ from the second reference voltage end VREF2, and generate a third sampling current signal $I_3$.

For example, the second sampling sub-circuit 321 is further electrically connected to the first voltage end VSS.

For example, a current value of the third sampling current signal $I_3$ is related to the voltage value of the second reference voltage signal $V_{REF2}$.

The current mirror 322 includes a current input end and a first current output end. The current input end of the current mirror 322 is electrically connected to the second sampling sub-circuit 321, and is configured to receive the third sampling current signal $I_3$. The first current output end is electrically connected to the first sampling circuit 31 and the inverter pair 33. For example, the first current output end is electrically connected to the first sampling circuit 31 via the first node net1 and the isolation circuit 35, and is electrically connected to the inverter pair 33 via the first node net1. The first current output end is configured to output the second sampling current signal $I_2$.

For example, the current mirror 322 is further electrically connected to the second voltage end VDD.

It may be understood that the current mirror 322 receives the third sampling current signal $I_3$, and the current mirror 322 may replicate the third sampling current signal $I_3$, to generate and output the second sampling current signal $I_2$. A direction of the second sampling current signal $I_2$ is the same as a direction of the third sampling current signal $I_3$, so that the second sampling current signal $I_2$ and the first sampling current signal $I_1$ are in a same direction at the first node net1, to pull up or pull down the voltage value at the first node net1.

The charge pump detection circuit 3 further includes a second bias voltage circuit 36. The second bias voltage circuit 36 is electrically connected to the second reference voltage end VREF2 and the current mirror 322, and the second bias voltage circuit 36 is configured to: receive the second reference voltage signal $V_{REF2}$ from the second reference voltage end VREF2, and output a second bias voltage $V_{bias2}$ to the current mirror 322, to control the current mirror 322 to work.

For example, the second bias voltage circuit 36 is further electrically connected to the first voltage end VSS.

In some embodiments, refer to FIG. 6. The inverter pair 33 is further indirectly electrically connected to the first voltage end VSS and the second voltage end VDD via an intermediate medium, and a first voltage and a second voltage are used to supply power to the inverter pair 33. For example, the inverter pair 33 is electrically connected to the second voltage end VDD via the current mirror 322.

Each inverter pair 33 includes a first-stage inverter 33a and a second-stage inverter 33b. The first-stage inverter 33a is electrically connected to the first sampling circuit 31 and the second sampling circuit 32. For example, the first-stage inverter 33a is electrically connected to the first sampling circuit 31 via the first node net and the isolation circuit 35, and is electrically connected to the second sampling circuit 32 via the first node net. The first-stage inverter 33a is configured to output a first drive voltage signal based on the first sampling current signal $I_1$ and the second sampling current signal $I_2$.

For example, refer to FIG. 6. The first-stage inverter 33a, the first sampling circuit 31, and the second sampling circuit 32 are all connected to the first node net1. For example, the first sampling circuit 31 is connected to the first node net1 via the isolation circuit 35, the second sampling sub-circuit 321 is connected to the first node net1 via the current mirror 322, and the first-stage inverter 33a is directly connected to the first node net1.

When the first sampling current signal $I_1$ and the second sampling current signal $I_2$ are compared at the first node net1, a voltage value of the first node net1 is affected (the voltage value of the first node net1 is pulled up or pulled down), so that a comparison voltage is generated at the first node net1. The first-stage inverter 33a may output the first drive voltage signal based on the comparison voltage.

Still refer to FIG. 6. The second-stage inverter 33b is electrically connected to the first-stage inverter 33a, and the second-stage inverter 33b is configured to: receive the first drive voltage signal from the first-stage inverter 33a, and output a second drive voltage signal.

The inverter pair 33 is disposed, and each inverter pair 33 includes two inverters (a first-stage inverter 33a and a second-stage inverter 33b), to ensure that the output second drive voltage signal is the same in polarity as a voltage of the first node net1.

In addition, the inverter may be configured to increase a swing of the output signal; and the second drive voltage signal is used as the control signal $V_{en}$, so that a driving capability of the control signal to the oscillator 4 can be improved.

In some other embodiments, a plurality of inverter pairs 33 may be disposed in the charge pump detection circuit 3, to further improve the swing of the output signal, so as to improve the driving capability of the output signal to the oscillator 4.

In some embodiments, refer to FIG. 6. The current mirror 322 further includes a second current output end, and the second current output end is configured to output a reference current signal $I_{ref}$.

The charge pump detection circuit 3 further includes a third sampling circuit 37. The third sampling circuit 37 is electrically connected to the second reference voltage end VREF2, and the third sampling circuit 37 is configured to: receive the second reference voltage signal $V_{REF2}$ from the second reference voltage end VREF2, and generate a fourth sampling current signal $I_4$.

For example, the third sampling circuit 37 is further electrically connected to the first voltage end VSS, and the inverter pair 33 is electrically connected to the first voltage end VSS via the third sampling circuit 37.

For example, a current value of the fourth sampling current signal $I_4$ is positively correlated with the voltage value of the second reference voltage signal $V_{REF2}$.

The first-stage inverter 33a is further electrically connected to the second current output end of the current mirror 322 and the third sampling circuit 37, and the first-stage inverter 33a is electrically connected to the first voltage end VSS via the third sampling circuit 37, and is electrically connected to the second voltage end VDD via the current mirror 322.

It may be understood that the reference current signal $I_{ref}$ and the fourth sampling current signal $I_4$ separately provide a bias current for the first-stage inverter 33a, and the first-stage inverter 33a is a current starving inverter, and the current starving inverter may be configured to increase a swing of the voltage of the first node net1, so that a swing of the first drive voltage signal output by the first-stage inverter 33a is increased, and a swing of the control signal $V_{en}$ is increased.

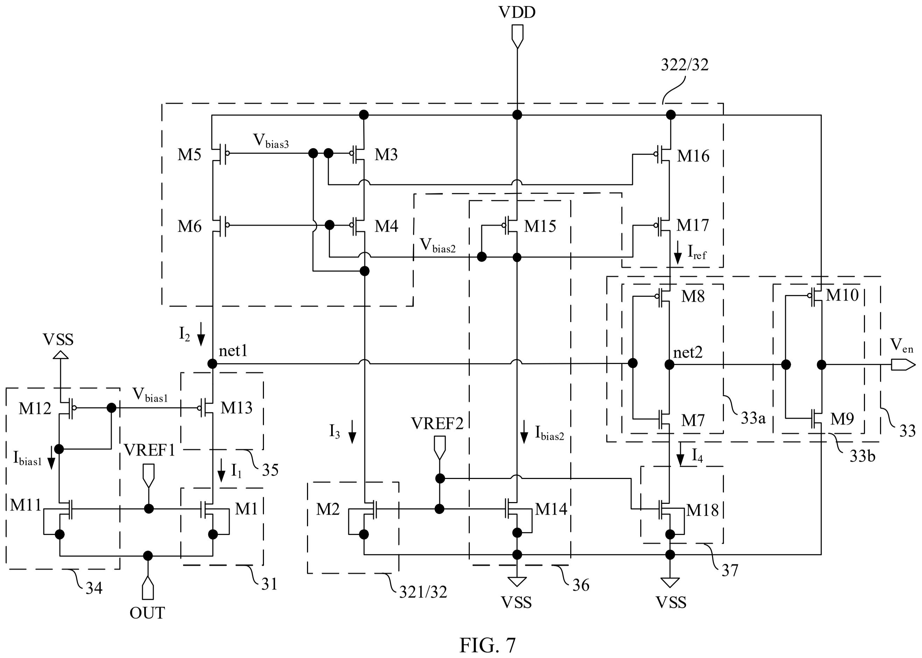

The following describes a specific circuit structure of the charge pump detection circuit 3 by using an example. FIG. 7 is a schematic of the charge pump detection circuit in FIG. 6.

Refer to FIG. 7. The first sampling circuit 31 includes a first transistor M1. A control electrode of the first transistor M1 is electrically connected to the first reference voltage end VREF1, and a first electrode of the first transistor M1 is electrically connected to the output end OUT of the charge pump 5. The control electrode of the first transistor M1 receives the first reference voltage signal $V_{REF1}$, and the first electrode of the first transistor M1 receives the power voltage signal $V_{NEG}$, to generate the first sampling current signal $I_1$ between the first electrode and a second electrode of the first transistor M1.

In the foregoing embodiment, the first transistor M1 may be of an N type. This is not limited in embodiments of this application.

In this specification, a control electrode of a transistor may be a gate of the transistor, a first electrode of the transistor may be one of a source or a drain, and a second electrode of the transistor may be the other of the source or the drain.

The first reference voltage end VREF1 is electrically connected to a gate of the first transistor M1, and almost no current is generated on the transmission trace of the first reference voltage signal $V_{REF1}$, thereby avoiding a large voltage drop generated in a process of transmitting the first reference voltage signal $V_{REF1}$ on the trace, and helping improve the accuracy of the power voltage value output by the charge pump 5.

In addition, because there is almost no current on the transmission trace of the first reference voltage signal $V_{REF1}$, a width of the trace is reduced, and trace channel space is saved.

In some embodiments, refer to FIG. 7. The second sampling circuit 32 includes the second sampling sub-circuit 321 and the current mirror 322. The second sampling sub-circuit 321 includes a second transistor M2. A control electrode of the second transistor M2 is electrically connected to the second reference voltage end VREF2, and a first electrode of the second transistor M2 is electrically connected to the first voltage end VSS. The control electrode of the second transistor M2 receives the second reference voltage signal $V_{REF2}$, and the first electrode of the second transistor M2 receives the first voltage, to generate the second sampling current signal $I_2$ between the first electrode and a second electrode of the second transistor M2.

Still refer to FIG. 7. The current mirror 322 includes a third transistor M3 to a sixth transistor M6, to form a self-biased cascode current mirror.

A first electrode of the third transistor M3 is electrically connected to the second voltage end VDD, a second electrode of the third transistor M3 is electrically connected to a first electrode of the fourth transistor M4, and a second electrode of the fourth transistor M4 is electrically connected to a control electrode of the third transistor M3 and a second electrode of the second transistor M2.

A first electrode of the fifth transistor M5 is electrically connected to the second voltage end VDD, a second electrode of the fifth transistor M5 is electrically connected to a first electrode of the sixth transistor M6, and a second electrode of the sixth transistor M6 is electrically connected to a second electrode of the first transistor M1. For example, the second electrode of the sixth transistor M6 is indirectly electrically connected to the second electrode of the first transistor M1 via an intermediate medium (a thirteenth transistor M13).

The control electrode of the third transistor M3 is electrically connected to a control electrode of the fifth transistor M5, and a control electrode of the fourth transistor M4 is electrically connected to a control electrode of the sixth transistor M6.

The third transistor M3, the fourth transistor M4, and the second transistor M2 are disposed in series, and the third sampling current signal $I_3$ generated in the second transistor M2 flows into the third transistor M3 through the fourth transistor M4, to generate a third bias voltage $V_{bias3}$ at the control electrode of the third transistor M3. The third bias voltage $V_{bias3}$ is used to provide a bias voltage for the fifth transistor M5.

In the foregoing embodiment, the second transistor M2 may be of an N type, and the third transistor M3 to the sixth transistor M6 each may be of a P type. This is not limited in embodiments of this application.

The second reference voltage end VREF2 is electrically connected to a gate of the second transistor M2, and almost no current is generated on a transmission trace of the second reference voltage signal $V_{REF2}$, thereby avoiding a large voltage drop generated in a process of transmitting the second reference voltage signal $V_{REF2}$ on the trace, and helping improve the accuracy of the power voltage value output by the charge pump 5.

In addition, because there is almost no current on the transmission trace of the second reference voltage signal $V_{REF2}$, a width of the trace is reduced, and trace channel space is saved.

In some embodiments, refer to FIG. 7. The inverter pair 33 includes the first-stage inverter 33a and the second-stage inverter 33b. The first-stage inverter 33a includes a seventh transistor M7 and an eighth transistor M8. A control electrode of the seventh transistor M7 is electrically connected to the second electrode of the first transistor M1 and the second electrode of the sixth transistor M6, and a first electrode of the seventh transistor M7 is electrically connected to the first voltage end VSS.

For example, the control electrode of the seventh transistor M7 is indirectly connected to the second electrode of the first transistor M1 via an intermediate medium (the thirteenth transistor M13), and the first electrode of the seventh transistor M7 is indirectly connected to the first voltage end VSS via an intermediate medium (an eighteenth transistor M18).

A control electrode of the eighth transistor M8 is electrically connected to the second electrode of the first transistor M1 and the second electrode of the sixth transistor M6, a first electrode of the eighth transistor M8 is electrically connected to the second voltage end VDD, and a second electrode of the eighth transistor M8 is electrically connected to a second electrode of the seventh transistor M7.

For example, the control electrode of the eighth transistor M8 is indirectly connected to the second electrode of the first transistor M1 via an intermediate medium (the thirteenth transistor M13), and the first electrode of the eighth transistor M8 is connected to the second voltage end VDD via an intermediate medium (a sixteenth transistor M16 and a seventeenth transistor M17).

For example, both the second electrode of the eighth transistor M8 and the second electrode of the seventh transistor M7 are connected to a second node net2.

The second-stage inverter 33b includes a ninth transistor M9 and a tenth transistor M10. A control electrode of the ninth transistor M9 is electrically connected to the second electrode of the seventh transistor M7 and the second electrode of the eighth transistor M8, and a first electrode of the ninth transistor M9 is electrically connected to the first voltage end VSS.

For example, the control electrode of the ninth transistor M9 is connected to the second node net2, and the first electrode of the ninth transistor M9 is directly connected to the first voltage end VSS.

A control electrode of the tenth transistor M10 is electrically connected to the second electrode of the seventh transistor M7 and the second electrode of the eighth transistor M8, a first electrode of the tenth transistor M10 is electrically connected to the second voltage end VDD, and a second electrode of the tenth transistor M10 is electrically connected to a second electrode of the ninth transistor M9.

For example, the control electrode of the tenth transistor M10 is connected to the second node net2, and the first electrode of the tenth transistor M10 is directly connected to the second voltage end VDD.

For example, both the second electrode of the ninth transistor M9 and the second electrode of the tenth transistor M10 are electrically connected to the oscillator 4.

In the foregoing embodiment, both the seventh transistor M7 and the ninth transistor M9 may be of an N type, and both the eighth transistor M8 and the tenth transistor M10 may be of a P type. This is not limited in embodiments of this application.

A current calculation formula is as follows:

$$I = \frac{1}{2} \times \mu \times C_{ox} \times \frac{W}{L} \times (V_{gs} - V_{th})^2$$

, where $\mu$ is a charge carrier mobility of a transistor; $C_{ox}$ is a channel capacitance per unit area of the transistor; $\frac{W}{L}$ is a channel width-to-length ratio of the transistor; $V_{gs}$ is a gate-source voltage difference of the transistor; and $V_{th}$ is a threshold voltage of the transistor.

Based on this, the first sampling current signal

$$I_1 = \frac{1}{2} \times \mu \times C_{ox} \times \frac{W}{L} \times (V_{REF1} - V_{NEG} - V_{th})^2 \quad ,$$

and the second samplin current signal

$$I_2 = \frac{1}{2} \times \mu \times C_{ox} \times \frac{W}{L} \times (V_{REF2} - V_{th})^2 \quad .$$

According to the foregoing description, the target voltage value of the power voltage signal $V_{NEG}$ is equal to the difference between the first reference voltage signal $V_{REF1}$ and the second reference voltage signal $V_{REF2}$, that is, the difference between the first reference voltage signal $V_{REF1}$ and the target voltage value of the power voltage signal $V_{NEG}$ is equal to the second reference voltage signal $V_{REF2}$.

Therefore, when the first transistor M1 and the second transistor M2 are the same transistor, and the power voltage signal $V_{NEG}$ is equal to the target voltage value, the current value of the first sampling current signal $I_1$ is equal to the current value of the second sampling current signal $I_2$.

The power voltage signal $V_{NEG}$ is a negative voltage. When the power voltage signal $V_{NEG}$ is higher than the target voltage value, the first sampling current signal $I_1$ is less than the second sampling current signal $I_2$. The voltage value of the first node net1 may be increased, the third transistor M3 in the first-stage inverter 33a enters a saturated region, and the fourth transistor M4 enters a cut-off region, so that a potential of the second node net2 is pulled down. The fifth transistor M5 in the second-stage inverter 33b enters a cut-off region, and the sixth transistor M6 enters a saturated region, to output a high-level control signal $V_{en}$. The oscillator 4 is turned on under the control of the control signal $V_{en}$, to transmit the clock signal clk to the charge pump 5, so as to control the charge pump 5 to pull down the output power voltage signal $V_{NEG}$.

When the power voltage signal $V_{NEG}$ is less than the target voltage value, the first sampling current signal $I_1$ is greater than the second sampling current signal $I_2$. The voltage value of the first node net1 may be pulled down, the third transistor M3 in the first-stage inverter 33a enters a cut-off region, and the fourth transistor M4 enters a saturated region, so that a potential of the second node net2 is pulled up. The fifth transistor M5 in the second-stage inverter 33b enters a saturated region, and the sixth transistor M6 enters a cut-off region, to output a low-level control signal $V_{en}$. The oscillator 4 stops outputting the clock signal under the control of the control signal $V_{en}$, the charge pump 5 stops working accordingly, and the power voltage signal $V_{NEG}$ is continuously pulled up under a load of the charge pump 5 until the power voltage signal $V_{NEG}$ reaches the target voltage value. This dynamically controls a power voltage.

In some embodiments, refer to FIG. 7. The first bias voltage circuit 34 includes an eleventh transistor M11 and a twelfth transistor M12. A control electrode of the eleventh transistor M11 is electrically connected to the first reference voltage end VREF1, and a first electrode of the eleventh transistor M11 is electrically connected to the output end OUT of the charge pump 5. The control electrode of the eleventh transistor M11 receives the first reference voltage signal $V_{REF1}$, and the first electrode of the eleventh transistor M11 receives the power voltage signal $V_{NEG}$, to generate a first bias current $I_{bias1}$ between the first electrode and a second electrode of the eleventh transistor M11.

A first electrode of the twelfth transistor M12 is electrically connected to a control electrode of the twelfth transistor M12 and a second electrode of the eleventh transistor M11, and a second electrode of the twelfth transistor M12 is electrically connected to the first voltage end VSS.

The twelfth transistor M12 and the eleventh transistor M11 are disposed in series, and the first bias current $I_{bias1}$ generated in the eleventh transistor M11 flows into the first electrode of the twelfth transistor M12, to generate the first bias voltage $V_{bias1}$ at the control electrode of the twelfth transistor M12.

Still refer to FIG. 7. The isolation circuit 35 includes the thirteenth transistor M13, and the first transistor M1 is electrically connected to the sixth transistor M6 via the thirteenth transistor M13. A control electrode of the thirteenth transistor M13 is electrically connected to the control electrode of the twelfth transistor M12, a first electrode of the thirteenth transistor M13 is electrically connected to the second electrode of the first transistor M1, and a second electrode of the thirteenth transistor M13 is indirectly connected to the sixth transistor M6 via the first node net1.

Under control of the first bias voltage $V_{bias1}$, the thirteenth transistor M13 may reduce impact of a voltage value change of the first node net1 on the first sampling current signal $I_1$, and reduce a voltage value change of the first sampling current signal $I_1$.

In the foregoing embodiment, the eleventh transistor M11 may be of an N type, and the twelfth transistor M12 and the thirteenth transistor M13 may be of a P type. This is not limited in embodiments of this application.

In some embodiments, refer to FIG. 7. The second bias voltage circuit 36 includes a fourteenth transistor M14 and a fifteenth transistor M15. A control electrode of the fourteenth transistor M14 is electrically connected to the second reference voltage end VREF2, and a first electrode of the fourteenth transistor M14 is electrically connected to the first voltage end VSS. The control electrode of the fourteenth transistor M14 receives the second reference voltage signal $V_{REF2}$, and the first electrode of the fourteenth transistor M14 receives the first voltage, to generate a second bias current $I_{bias2}$ between the first electrode and a second electrode of the fourteenth transistor M14.

A first electrode of the fifteenth transistor M15 is electrically connected to the second voltage end VDD, and a second electrode of the fifteenth transistor M15 is electrically connected to a control electrode of the fifteenth transistor M15, a second electrode of the fourth transistor M14, and the control electrode of the sixth transistor M6.

The fifteenth transistor M15 and the fourteenth transistor M14 are disposed in series, and the second bias current $I_{bias2}$ generated in the fourteenth transistor M14 flows into the second electrode of the fifteenth transistor M15, to generate the second bias voltage $V_{bias2}$ at the control electrode of the fifteenth transistor M15. The second bias voltage $V_{bias2}$ is used to provide a bias voltage for the fourth transistor M4 and the sixth transistor M6.

Based on this, when the third transistor M3 and the fifth transistor M5 are a same transistor, and the fourth transistor M4 and the sixth transistor M6 are a same transistor, the fifth transistor M5 is biased by the third bias voltage $V_{bias3}$, the fourth transistor M4 and the sixth transistor M6 are biased by the second bias voltage $V_{bias2}$, and the current mirror 322 replicates the third sampling current signal $I_3$ from the second transistor M2, to generate and output the second sampling current signal $I_2$ to the first node net1.

In the foregoing embodiment, the fourteenth transistor M14 may be of an N type, and the fifteenth transistor M15 may be of a P type. This is not limited in embodiments of this application.

In some embodiments, refer to FIG. 7. The current mirror 322 further includes the sixteenth transistor M16 and the seventeenth transistor M17. A control electrode of the sixteenth transistor M16 is electrically connected to the control electrode of the third transistor M3, and a first electrode of the sixteenth transistor M16 is electrically connected to the second voltage end VDD. A control electrode of the seventeenth transistor M17 is electrically connected to the control electrode of the fifteenth transistor M15, a first electrode of the seventeenth transistor M17 is electrically connected to a second electrode of the sixteenth transistor M16, and a second electrode of the seventeenth transistor M17 is electrically connected to the first electrode of the eighth transistor M8.

Based on this, when the third transistor M3 and the sixteenth transistor M16 are a same transistor, and the fourth transistor M4 and the seventeenth transistor M17 are a same transistor, the sixteenth transistor M16 is biased by the third bias voltage $V_{bias3}$, the seventeenth transistor M17 is biased by the second bias voltage $V_{bias2}$, and the current mirror 322 replicates and outputs the reference current signal $I_{ref}$ based on the third sampling current signal $I_3$ from the second transistor M2.

Refer to FIG. 7. The third sampling circuit 37 includes the eighteenth transistor M18. A control electrode of the eighteenth transistor M18 is electrically connected to the second reference voltage end VREF2, a first electrode of the eighteenth transistor M18 is electrically connected to the first voltage end VSS, and a second electrode of the eighteenth transistor M18 is electrically connected to the first electrode of the seventh transistor M7. The control electrode of the eighteenth transistor M18 receives the second reference voltage signal $V_{REF2}$, and the first electrode of the eighteenth transistor M18 receives the first voltage, to generate the fourth sampling current signal $I_4$ between the first electrode and the second electrode of the eighteenth transistor M18.

In the foregoing embodiment, the reference current signal $I_{ref}$ flows into the first electrode of the eighth transistor M8, and the fourth sampling current signal $I_4$ flows into the first electrode of the seventh transistor M7, to provide the bias current for the first-stage inverter 33a.

In addition, both the sixteenth transistor M16 and the seventeenth transistor M17 may be of a P type, and the eighteenth transistor M18 may be of an N type. This is not limited in embodiments of this application.

In the foregoing embodiments of this application, the first transistor M1 to the eighteenth transistor M18 each may be a metal-oxide-semiconductor field-effect transistor (Metal-Oxide-Semiconductor Field-Effect Transistor, MOSFET). The MOSFET occupies a small area, and is low in preparation process difficulty.

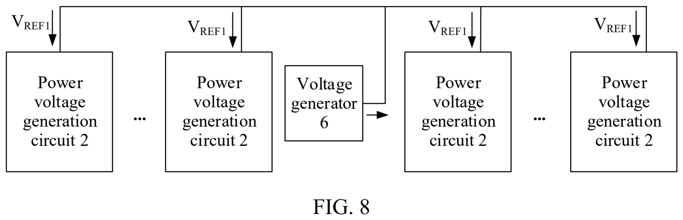

FIG. 8 is a block diagram of a structure of a memory according to an embodiment of this application.

Refer to FIG. 8. An internal memory 112 further includes a voltage generator 6, and the voltage generator 6 is configured to output the first reference voltage signal $V_{REF1}$.

A plurality of power voltage generation circuits 2 are electrically connected to the voltage generator 6. In charge pump detection circuits 3 of the plurality of power voltage generation circuits 2, first reference voltage ends VREF1 are electrically connected to the voltage generator 6, to receive the first reference voltage signal $V_{REF1}$.

As mentioned above, almost no current is generated on the transmission trace of the first reference voltage signal $V_{REF1}$, thereby avoiding a large voltage drop generated in a process of transmitting the first reference voltage signal $V_{REF1}$ on the trace, avoiding a large deviation between the voltage value received by the first reference voltage end VREF1 and the voltage value output by the voltage generator 6, and helping improve the accuracy of the power voltage value output by the charge pump 5.

According to the power voltage generation circuit, the memory, and the electronic device provided in embodiments of this application, the power voltage generation circuit includes the charge pump detection circuit, the oscillator, and the charge pump. In the charge pump detection circuit, the first sampling circuit receives the first reference voltage signal and the power voltage signal, and generates the first sampling current signal, so that almost no current is generated on the transmission trace of the first reference voltage signal, thereby avoiding the large voltage drop generated in the process of transmitting the first reference voltage signal on the trace, and improving the accuracy of the received first reference voltage signal. In addition, the second sampling circuit receives the second reference voltage signal, and generates the second sampling current signal.

Based on this, the inverter pair may output the control signal based on the first sampling current signal and the second sampling current signal. The oscillator generates the clock signal in response to the control signal, and the charge pump may generate and output the power voltage signal based on the clock signal. When the accuracy of the first reference voltage signal is improved, the accuracy of the power voltage value output by the charge pump is improved.

For example, a transmission trace of a reference voltage signal is electrically connected to a gate of a transistor, and almost no current is generated on the transmission trace of the reference voltage signal, thereby avoiding a large voltage drop generated in a process of transmitting the reference voltage signal on the trace, and helping improve the accuracy of the power voltage value output by the charge pump.

In addition, because there is almost no current on the transmission trace of the reference voltage signal, a width of the trace is reduced, and trace channel space is saved.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A power voltage generation circuit, comprising a charge pump, a charge pump detection circuit, and an oscillator, wherein an output end of the charge pump is configured to output a power voltage signal;
   the charge pump detection circuit comprises:

   a first sampling circuit, configured to: receive a first reference voltage signal and the power voltage signal, and generate a first sampling current signal;
   a second sampling circuit, configured to: receive a second reference voltage signal, and generate a second sampling current signal; and
   at least one inverter pair, electrically connected to the first sampling circuit and the second sampling circuit, and configured to output a control signal based on the first sampling current signal and the second sampling current signal;
   the oscillator is configured to generate a clock signal based on the control signal; and

   the charge pump is configured to generate the power voltage signal based on the clock signal.

2. The power voltage generation circuit according to claim 1, wherein a target voltage value of the power voltage signal is a difference between the first reference voltage signal and the second reference voltage signal.

3. The power voltage generation circuit according to claim 1 or 2, wherein the charge pump detection circuit further comprises a first bias voltage circuit and an isolation circuit, wherein

   the first bias voltage circuit is electrically connected to the output end of the charge pump, and is configured to:
   receive the first reference voltage signal and the power voltage signal, and output a first bias voltage; and
   the isolation circuit is electrically connected to the first bias voltage circuit, and is connected between the first sampling circuit and the second sampling circuit.

4. The power voltage generation circuit according to any one of claims 1 to 3, wherein the second sampling circuit comprises a second sampling sub-circuit and a current mirror, and the second sampling sub-circuit is configured to: receive the second reference voltage signal and generate a third sampling current signal;

   the current mirror comprises a current input end and a first current output end, the current input end is electrically connected to the second sampling sub-circuit, and is configured to receive the third sampling current signal, and the first current output end is electrically connected to the first sampling circuit and the inverter pair, and is configured to output the second sampling current signal; and
   the charge pump detection circuit further comprises a second bias voltage circuit that is electrically connected to the current mirror and configured to: receive the second reference voltage signal, and output a second bias voltage to the current mirror.

5. The power voltage generation circuit according to claim 4, wherein the inverter pair comprises a first-stage inverter and a second-stage inverter, wherein

   the first-stage inverter is electrically connected to the first sampling circuit and the second sampling circuit, and
   the first-stage inverter is configured to output a first drive voltage signal based on the first sampling current signal and the second sampling current signal; and

the second-stage inverter is electrically connected to the first-stage inverter, and is configured to: receive the first drive voltage signal, and output a second drive voltage signal, wherein the second drive voltage signal is the control signal.

6. The power voltage generation circuit according to claim 5, wherein the current mirror further comprises a second current output end;

the charge pump detection circuit further comprises a third sampling circuit that is configured to: receive the second reference voltage signal, and generate a fourth sampling current signal; and

the first-stage inverter is further electrically connected to the second current output end and the third sampling circuit.

7. The power voltage generation circuit according to any one of claims 1 to 6, wherein the charge pump detection circuit further comprises a first reference voltage end, and the first reference voltage end is configured to receive the first reference voltage signal; and

the first sampling circuit comprises a first transistor, a control electrode of the first transistor is electrically connected to the first reference voltage end, and a first electrode of the first transistor is electrically connected to the output end of the charge pump.

8. The power voltage generation circuit according to claim 7, wherein the charge pump detection circuit further comprises a first voltage end, a second voltage end, and a second reference voltage end, and the second reference voltage end is configured to receive the second reference voltage signal;

the second sampling circuit comprises the second sampling sub-circuit and the current mirror, the second sampling sub-circuit comprises a second transistor, a control electrode of the second transistor is electrically connected to the second reference voltage end, and a first electrode of the second transistor is electrically connected to the first voltage end;

the current mirror comprises a third transistor to a sixth transistor, a first electrode of the third transistor is electrically connected to the second voltage end, a second electrode of the third transistor is electrically connected to a first electrode of the fourth transistor, and a second electrode of the fourth transistor is electrically connected to a control electrode of the third transistor and a second electrode of the second transistor;

a first electrode of the fifth transistor is electrically connected to the second voltage end, a second electrode of the fifth transistor is electrically connected to a first electrode of the sixth transistor, and a second electrode of the sixth transistor is electrically connected to a second electrode of the first transistor; and

the control electrode of the third transistor is electrically connected to a control electrode of the fifth transistor, and a control electrode of the fourth transistor is electrically connected to a control electrode of the sixth transistor.

9. The power voltage generation circuit according to claim 8, wherein the inverter pair comprises the first-stage inverter and the second-stage inverter; and the first-stage inverter comprises a seventh transistor and an eighth transistor, a control electrode of the seventh transistor is electrically connected to the second electrode of the first transistor and the second electrode of the sixth transistor, and a first electrode of the seventh transistor is electrically connected to the first voltage end;

a control electrode of the eighth transistor is electrically connected to the second electrode of the first transistor and the second electrode of the sixth transistor, a first electrode of the eighth transistor is electrically connected to the second voltage end, and a second electrode of the eighth transistor is electrically connected to a second electrode of the seventh transistor;

the second-stage inverter comprises a ninth transistor and a tenth transistor, a control electrode of the ninth transistor is electrically connected to the second electrode of the seventh transistor and the second electrode of the eighth transistor, and a first electrode of the ninth transistor is electrically connected to the first voltage end; and

a control electrode of the tenth transistor is electrically connected to the second electrode of the seventh transistor and the second electrode of the eighth transistor, a first electrode of the tenth transistor is electrically connected to the second voltage end, and a second electrode of the tenth transistor is electrically connected to a second electrode of the ninth transistor.

10. The power voltage generation circuit according to claim 8 or 9, wherein the charge pump detection circuit further comprises the first bias voltage circuit and the isolation circuit;

the first bias voltage circuit comprises an eleventh transistor and a twelfth transistor, a control electrode of the eleventh transistor is electrically connected to the first reference voltage end, and a first electrode of the eleventh transistor is electrically connected to the output end of the charge pump; and a first electrode of the twelfth transistor is electrically connected to a control electrode and a second electrode of the eleventh transistor, and a second electrode of the twelfth transistor is electrically connected to the first voltage end; and

the isolation circuit comprises a thirteenth transistor, the first transistor is electrically connected to the sixth transistor via the thirteenth transistor, and a control electrode of the thirteenth transistor is electrically connected to the control electrode of the twelfth transistor.

11. The power voltage generation circuit according to claim 9, wherein the charge pump detection circuit further comprises the second bias voltage circuit;

the second bias voltage circuit comprises a fourteenth transistor and a fifteenth transistor, a control electrode of the fourteenth transistor is electrically connected to the second reference voltage end, and a first electrode of the fourteenth transistor is electrically connected to the first voltage end;

a first electrode of the fifteenth transistor is electrically connected to the second voltage end, and a second electrode of the fifteenth transistor is electrically connected to a control electrode, a second electrode of the fourteenth transistor, the control electrode of the fourth transistor, and the control electrode of the sixth transistor.

12. The power voltage generation circuit according to claim 11, wherein the current mirror further comprises a sixteenth transistor and a seventeenth transistor;

a control electrode of the sixteenth transistor is electrically connected to the control electrode of the third transistor, and a first electrode of the sixteenth transistor is electrically connected to the second voltage end;

a control electrode of the seventeenth transistor is electrically connected to the control electrode of the fifteenth transistor, a first electrode of the seventeenth transistor is electrically connected to a second electrode of the sixteenth transistor, and a second electrode of the seventeenth transistor is electrically connected to the first electrode of the eighth transistor; and

the charge pump detection circuit further comprises the third sampling circuit, the third sampling circuit comprises an eighteenth transistor, a control electrode of the eighteenth transistor is electrically connected to the second reference voltage end, a first electrode of the eighteenth transistor is electrically connected to the first voltage end, and a second electrode of the eighteenth transistor is electrically connected to the first electrode of the seventh transistor.

13. A memory, comprising:

the power voltage generation circuit according to any one of claims 1 to 12; and a memory array, electrically connected to the power voltage generation circuit.

14. The memory according to claim 13, wherein the memory comprises a plurality of power voltage generation circuits; and the memory array is electrically connected to the plurality of power voltage generation circuits.

15. The memory according to claim 13 or 14, wherein the memory further comprises a voltage generator that is configured to output the first reference voltage signal; and in the power voltage generation circuit, the charge pump detection circuit comprises the first reference voltage end, and the first reference voltage end is electrically connected to the voltage generator.

16. An electronic device, comprising:

the memory according to any one of claims 13 to 15; and a processor, electrically connected to the memory.

FIG. 1

FIG. 2

112

Timing control circuit 24

Read/Write control circuit 25

Row decoding circuit 22

Memory array 21

Memory cell 210  ...  Memory cell 210

⋮  ⋮

Memory cell 210  ...  Memory cell 210

Sensitive amplifier 26

Column decoding circuit 23

Y

X

FIG. 3

2

$V_{REF1}$

$V_{REF2}$

Charge pump detection circuit 3

$V_{en}$

Oscillator 4

clk

Charge pump 5

$V_{NEG}$

FIG. 4

<u>2</u>

VREF2

Second sampling circuit 32

$I_2$ ↓

● net1

$I_1$ ↓

First sampling circuit 31

Inverter pair 33

$V_{en}$

Oscillator 4

clk

Charge pump 5

OUT

$V_{NEG}$

3

VREF1    OUT

FIG. 5

FIG. 6

EP 4 685 801 A1

FIG. 7

$V_{REF1}$    $V_{REF1}$    $V_{REF1}$    $V_{REF1}$

| Power voltage generation circuit 2 | ... | Power voltage generation circuit 2 | Voltage generator 6 | Power voltage generation circuit 2 | ... | Power voltage generation circuit 2 |

FIG. 8

## INTERNATIONAL SEARCH REPORT

| International application No. |
|---|
| **PCT/CN2023/138542** |

| A. | CLASSIFICATION OF SUBJECT MATTER |
|---|---|
| | G11C16/06(2006.01)i; G11C16/30(2006.01)i; G11C 5/14(2006.01)i; H03L7/06(2006.01)i |

According to International Patent Classification (IPC) or to both national classification and IPC

| B. | FIELDS SEARCHED |
|---|---|

Minimum documentation searched (classification system followed by classification symbols)

IPC:G11C H03L

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 存储器, 电源电压, 电荷泵, 振荡器, 电流, 反相器, 比较器, 偏置电压, 隔离, 电流镜, 晶体管, memory, power supply voltage, charge pump, oscillator, current, inverter, comparator, bias voltage, isolation, current mirror, transistor

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 114627936 A (STMICROELECTRONICS INTERNATIONAL N.V.) 14 June 2022 (2022-06-14) claims 1-4 | 1-16 |
| A | CN 104091615 A (SHANGHAI HUAHONG GRACE SEMICONDUCTOR MANUFACTURING CORP.) 08 October 2014 (2014-10-08) entire document | 1-16 |
| A | CN 106208677 A (SANDISK TECHNOLOGIES LLC.) 07 December 2016 (2016-12-07) entire document | 1-16 |
| A | CN 107707115 A (SEMICONDUCTOR MANUFACTURING INTERNATIONAL (TIANJIN) CO., LTD. et al.) 16 February 2018 (2018-02-16) entire document | 1-16 |
| A | CN 112687312 A (TAIWAN SEMICONDUCTOR MANUFACTURING CO., LTD.) 20 April 2021 (2021-04-20) entire document | 1-16 |

☑ Further documents are listed in the continuation of Box C. ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **21 February 2024** | **26 February 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2023/138542** |

### C. DOCUMENTS CONSIDERED TO BE RELEVANT

| Category* | Citation of document, with indication, where appropriate, of the relevant passages | Relevant to claim No. |
|---|---|---|
| A | US 7102400 B1 (SITEL SEMICONDUCTOR B.V.) 05 September 2006 (2006-09-05) entire document | 1-16 |

Form PCT/ISA/210 (second sheet) (July 2022)

**INTERNATIONAL SEARCH REPORT**
Information on patent family members

International application No.

**PCT/CN2023/138542**

| Patent document cited in search report | | | Publication date (day/month/year) | Patent family member(s) | | | Publication date (day/month/year) |
|---|---|---|---|---|---|---|---|
| CN | 114627936 | A | 14 June 2022 | US | 2022180944 | A1 | 09 June 2022 |
| | | | | CN | 217157721 | U | 09 August 2022 |
| CN | 104091615 | A | 08 October 2014 | | None | | |
| CN | 106208677 | A | 07 December 2016 | US | 2016352217 | A1 | 01 December 2016 |
| CN | 107707115 | A | 16 February 2018 | | None | | |
| CN | 112687312 | A | 20 April 2021 | TW | 202117710 | A | 01 May 2021 |
| | | | | KR | 20220075277 | A | 08 June 2022 |
| | | | | US | 2021119531 | A1 | 22 April 2021 |
| | | | | KR | 20210047223 | A | 29 April 2021 |
| | | | | US | 2023396161 | A1 | 07 December 2023 |
| | | | | DE | 102019129096 | A1 | 22 April 2021 |
| | | | | US | 2022263409 | A1 | 18 August 2022 |
| US | 7102400 | B1 | 05 September 2006 | | None | | |

Form PCT/ISA/210 (patent family annex) (July 2022)

## REFERENCES CITED IN THE DESCRIPTION

**Patent documents cited in the description**

- CN 202310372877